Europäisches Patentamt

European Patent Office

Office européen des brevets

(11) Veröffentlichungsnummer: **0 357 616 B1**

(12) **EUROPÄISCHE PATENTSCHRIFT**

(45) Veröffentlichungstag der Patentschrift: **25.05.94**

(21) Anmeldenummer: **88902462.6**

(22) Anmeldetag: **15.03.88**

(86) Internationale Anmeldenummer:
**PCT/EP88/00203**

(87) Internationale Veröffentlichungsnummer:
**WO 89/08819 (21.09.89 89/23)**

(51) Int. Cl.5: **G01D 3/02**, G01L 1/22,
H03M 1/06

Die Akte enthält technische Angaben, die nach
dem Eingang der Anmeldung eingereicht wurden
und die nicht in dieser Patentschrift enthalten sind.

(54) **VERFAHREN UND VORRICHTUNG ZUR MESSFEHLERKOMPENSATION.**

(43) Veröffentlichungstag der Anmeldung:
**14.03.90 Patentblatt 90/11**

(45) Bekanntmachung des Hinweises auf die
Patenterteilung:
**25.05.94 Patentblatt 94/21**

(84) Benannte Vertragsstaaten:
**DE FR GB IT NL SE**

(56) Entgegenhaltungen:
**WO-A-83/04435**
**DE-A- 3 151 743**
**US-A- 4 107 667**

**Electronic Engineering, vol. 55, no. 680, August 1983 (London, GB), J. Lacy et al: "Enhancing the dynamic range of an A/D converter", pages 49-52, 57**

(73) Patentinhaber: **Divetronic AG**
**Rennhofstrasse 546**
**FL-9493 Mauren(LI)**

(72) Erfinder: **HERMANN, Jürgen**
**Rennhofstr. 546**
**FL-9493 Mauren(LI)**

(74) Vertreter: **Flach, Dieter Rolf Paul, Dipl.-Phys. et al**
**Patentanwälte**
**Andrae/Flach/Haug/Kneissl**
**Prinzregentenstrasse 24**
**D-83022 Rosenheim (DE)**

**Beschreibung**

Die Erfindung betrifft ein Verfahren zur Kompensation und/oder Formung externer Meßsignale mittels eines im Dual-Slope-Verfahren betreibbaren Analog-Digital-Konverters sowie eine zugehörige Vorrichtung zur Signalkompensation und/oder -formung nach Anspruch 1 bzw. 6.

Sensoren und dabei wiederum auch piezoresistive Sensoren haben sich in der heutigen Technik voll durchgesetzt und bilden einen unabkömmlichen Bestandteil für einen Meß-, Steuer- und/oder Regelkreis. Hierüber können konkrete Meßwerte erfaßt und dann weiter verarbeitet werden.

In der Praxis stellt sich allerdings das Problem, daß das beispielsweise an einer Meßbrücke abgegriffene Meßsignal mit vielfältigen Meßfehlern behaftet sein kann. Ferner ist es wünschenswert, auch herkömmliche Sensoren im Verbund mit Mikroprozessoren einzusetzen. Dabei muß auf jeden Fall zunächst das in einem analogen Meßkreis gewonnene Meßsignal einer Analog-Digital-Wandlung unterzogen werden.

Aus der US-A 4,192,005 ist es bekannt, das analoge Meßsignal eines piezoresistiven Senors über einen Analog-Digital-Wandler zu digitalisieren und digital weiter zu verarbeiten. Dies führt allerdings zu einem extremen Verlust der Analog-Digital-Konverter-Auflösung, da die Empfindlichkeit- und Offsetkompensation nicht vorab vorgenommen werden kann.

Ein gegenüber dem zuletzt genannten Stand der Technik verbessertes Verfahren zur Meßfehlerkompensation ist aus der EP-A 0 169 414 bekannt geworden. Das hieraus bekannte Meßverfahren bzw. die entsprechende Vorrichtung zur Durchführung des Meßverfahrens umfaßt einen in digitalisierter Form arbeitenden Kompensationskreis. Die analog erhaltenen Meßsignale werden dabei analog weiter verarbeitet, wobei lediglich in einem Regelkreis ein analoges Meßsignal digitalisiert wird, um dann entsprechend vorabgespeicherte, aufgrund einer Eichung erhaltene digitalisierte Kompensations- und Signalformunswerte abzurufen und der Meßschaltung zurückzuführen. Für eine Weiterverarbeitung der analogen Meßsignale in einem Mikroprozessor ist es dann aber immer noch erforderlich, die kompensierten analogen Meßsignale zu digitalisieren.

Von daher stellt sich weiterhin das grundsätzliche Problem, wie die folgenden möglicherweise auftretenden Fehler mit einfachen Mitteln bestmöglich minimiert, unterdrückt oder kompensiert werden können. Folgende Punkte sind dabei zu beachten:

a) Ein möglicher Meßfehler betrifft die "Nullpunktverschiebung und -streuung der Meßwerte", die durch die unterschiedlichen Widerstandswerte der Widerstände in den beiden Armen der Meßbrücke verursacht werden, so daß auch ohne angelegtem Druck am Drucksensor ein Nullpunkt-Fehlerdrucksignal auftritt.

b) Ein weiterer Fehler tritt durch "Temperatureinflüsse" auf, die Einfluß haben auf die Nullpunktverschiebung wie auch auf die Empfindlichkeit der Meßbrücke.

c) Ein weiterer Fehler betrifft den Linearitätsfehler. Mit anderen Worten ist das erhaltene Druck-Meßsignal nicht völlig linear zum angelegten Druck. Insbesondere bei hoher Genauigkeit muß hier eine Korrektur vorgenommen werden.

d) Einen weiteren Fehler bilden die "Empfindlichkeitsstreuungen" der Sensorzelle, die durch Herstellungstoleranzen bedingt sind, wodurch die einzelnen Druckzellen unterschiedliche Empfindlichkeiten aufweisen, weshalb es gilt, den Meßkreis entsprechend abzugleichen.

e) Schließlich können auch noch "Hysteresefehler" und "Wiederholbarkeitsfehler" auftreten (nur schwer erfaßbar).

f) Schließlich treten auch "Langzeit-Instabilitäten" auf, die grundsätzlich am Anfang nicht zu erfassen sind und die bei Langzeiteinsätzen zunehmend größer werden und den Nullpunkt verfälschen.

Aus der US-A 4,107,667 ist ein Verfahren sowie eine Vorrichtung zur Meßfehlerkompensation mittels eines im Dual-Slope-Verfahren betreibbaren Konverters bekannt geworden. Hierdurch soll das mittels eines Sensors ermittelte analoge Signal digitalisiert und dann eine entsprechende Meßfehlerkompensation, -korrektur und/oder -signalformung der analogen Meßsignale durchgeführt werden. Gemäß dieser Druckschrift wird die Kompensation, Korrektur und/oder Signalformung während der Digitalisierung der analogen Meßsignale durchgeführt, wozu Kompensations-, Korrektur- und/oder Signalformungs-Signale dem Analog-Digital-Konverter als diesen beeinflussende Steuer-Betriebsgrößen zugeführt und die am Analog-Digital-Konverter anstehenden analogen Meßsignale so verarbeitet werden, daß am Ausgang des Analog-Digital-Konverters ein von den Kompensations-, Korrektur- bzw. Signalformungswerten abhängiges modifiziertes digitalisiertes Ausgangssignal ansteht.

Allerdings ist der gesamte Aufbau dieser Anordnung hartverdrahtet und ermöglicht von daher keine vorprogrammierbare mikroprozessorunterstützte Verarbeitung. Von daher ist eine zumindest einfache und schnelle Anpassung an unterschiedliche Sensortypen nicht oder nur sehr eingeschränkt möglich. Ferner nachteilig ist die nur unzureichende Auflösung.

Ein Analog-Digital-Konverter ist grundsätzlich auch aus der vorveröffentlichten Druckschrift "Electronic Engineering", vol. 55, No. 680, August 1983 (London, GB)., J. Lacy et al.: "Enhancing the dynamic range of an A/D converter", pages 49-52, 57 beschrieben.

Es handelt sich bei dieser Vorveröffentlichung um eine allgemeine Untersuchung zur verbesserten Analog-Digital-Konvertierung, wobei anhand dieser Abhandlungen interne im Analog-Digital-Konverter auftretende Meßwertverfälschungen kompensiert werden sollen. Der in dieser Vorveröffentlichung konkret beschriebene Analog-Digital-Konverter arbeitet nach dem Verfahren der sukzessiven Approximation, also auf der Basis eines schrittweisen Annäherungsverfahrens. Derartige iterative Wandler-Verfahren weisen aber Nachteile auf. Zudem ist der anhand von Figur 4 beschriebene Schaltungsaufbau, zumindest was die Kompensation des Signalfehlers betrifft, zum Teil hart-verdrahtet und nicht mikroprozessor-gesteuert aufgebaut. Auch wenn in dieser Vorveröffentlichung festgehalten ist, daß die gemachten Ausführungen grundsätzlich auch für andere Analog-Digital-Konverter-Typen gelten können, ist keine wörtliche Aussage darüber getroffen, ob die in dieser Vorveröffentlichung beschriebenen Verfahrensschritte und Prinzipien vom Grundsatz her auch auf einen Analog-Digital-Konverter anwendbar sind, der im Dual-Slope-Verfahren betrieben wird.

Aufgabe der vorliegenden Erfindung ist es von daher ein Verfahren sowie eine Vorrichtung zur Meßfehlerkompensation, -korrektur und/oder Signalformung zu schaffen, wodurch es insbesondere im Falle von piezoresistiven Sensoren ermöglicht wird ein Meßsignal mit höchster Genauigkeit und Exaktheit zu digitalisieren, wobei auch eine Nullpunktkompensation mit einfachen und wirksamen Mitteln problemlos durchführbar sein soll.

Die Aufgabe wird erfindungsgemäß bezüglich des Verfahrens entsprechend den im Anspruch 1 und bezüglich der Vorrichtung entsprechend den im Anspruch 6 angegebenen Merkmalen gelöst. Vorteilhafte Ausgestaltungen der Erfindung sind in den abhängigen Ansprüchen angegeben.

Durch die vorliegende Erfindung wird ein erstmals mikroprozessorgesteuerter nach dem Dual-Slope-Verfahren arbeitender Analog-Digital-Konverter vorgeschlagen, mit welchem auch eine Nullpunktkompensation nicht nur für Abweichungen interner Schaltkreise, sondern vor allem auch für Abweichspannungen des externen Meßsignals möglich ist.

Eine exakte und vor allem auch vorprogrammierbare Digitalisierung des analogen Meßsignals mit entsprechender Meßwert-Formgebung läßt sich besonders problemlos auch deshalb durchführen, weil das Signal zur Nullpunktkompensation an den einen Eingang des Integrators und das analoge Meßsignal sowie zeitlich dazu versetzt das Referenzspannungs-Signal an den anderen Eingang des Integrators angelegt wird.

Bei der Erfindung wird also eine Kompensation der Signalformung unter Berücksichtigung der vorstehenden Besonderheiten während der Analog-Digital-Konversion durchgeführt. Eine entsprechende Kompensation und Signalformung vor der Wandlung würde nämlich ansonsten eine zusätzliche Verstärkung des ursprünglichen Meßsignals erfordern, was zum einen einen hohen Stromverbrauch erfordert und zum anderen zu einem zusätzlichen nicht korrigierbaren Fehler führt.

Eine Kompensation des Meßsignals nach einer entsprechenden Signalformung und nach einer Analog-Digital-Wandlung würde schließlich zu einer nicht mehr korrigierbaren Beschneidung des ursprünglichen Meßsignals mit einem Fehler- und Informationsverlust führen. Dabei eignet sich das Dual-Slope-Verfahren insbesondere deshalb, da hier in dreifacher Weise eine Kombination durchgeführt werden kann, nämlich einmal in einer Ruhephase durch eine Niveau- oder Pegelverschiebung, in der negativen Flankenphase durch vorwählbare Einstellung und Veränderung der Phasendauer T der Eingangs-Signal-Integration, und in der sich daran anschließenden positiven Flankenphase durch vorwählbare Einstellung und Veränderung der aufzuintegrierenden Referenzspannung.

Der mikroprozessor-gestützte Aufbau ermöglicht auch eine sogenannte Master-Slave-Betriebsweise, über welche auch ein angeschlossener Mikroprozessor steuerbar ist. Die Vorrichtung kann aber auch im sogenannten Stand-Alone-Mode oder aber sogar in einer "Kaskaden-Anordnung" betrieben werden, bei der mehrere Vorrichtung über einen Mikrobus miteinander verknüpft sind. Durch den programmierbaren Aufbau der Analog-Digital-Konversion-Signalanpaßverarbeitung ist eine beliebige Anpassung an bestimmte technische Bedürfnisse möglich, wobei durch den integrierten Mikroprozessor auch beliebige Kompensationswerte zwischen zwei abgespeicherten Werten berechen- und umsetzbar sind, was vor allem bei der Messung der Eichwerte sehr vorteilhaft ist, da dadurch nur relativ wenige Eichpunkte gemessen und dazwischenliegende Werte rechnergesteuert interpoliert werden können. Auch die Auflösung kann in beliebigen Verhältnissen leicht programmierbar und damit eine gewünschte Kurvenanpassung (Signal fitting) vorgenommen werden.

Weitere beachtliche Vorteile ergeben sich durch Verwendung eines EEPROM als zuschaltbares Modul, das selbst bei niedriger Spannung programmierbar ist und der Abspeicherung aller Einstellwerte und Parameter des Signalprozessors dient.

Ein bevorzugter Aufbau der Vorrichtung erfolgt nach Art eines Mikrochips, der über eine Mikrobus-Schnittstelle mit einem Computer verbindbar ist. Über den auf dem Chip enthaltenen Mikroprozessor können über den Interbus die EEPROM programmierten Kompensationswerte abgerufen, verarbeitet und dann der programmierbaren Analog-Digital-Konverter-Anpaß-Vorrichtung (PADCAS) aufgeschaltet werden, welche ihrerseits die Signalkompensation während der Analog-/Digital-Wandlung automatisch vornimmt.

Weitere Vorteile, Einzelheiten und Merkmale der Erfindung ergeben sich nachfolgend aus dem anhand von Zeichnungen dargestellten Ausführungsbeispiel. Dabei zeigen im einzelnen:

Figur 1 : ein Anschlußdiagramm der Vorrichtung zur Meßfehlerkompensation, Signalformung und/oder -verarbeitung;

Figur 2 : ein Blockdiagramm der in Figur 1 gezeigten Vorrichtung;

Figur 3a : ein beispielhaftes Temperatur-Zeit-Profil , und

Figur 3b : ein beispielhaftes Druck-Zeit-Profil zur Erstellung von Norm- und Eichwerten.

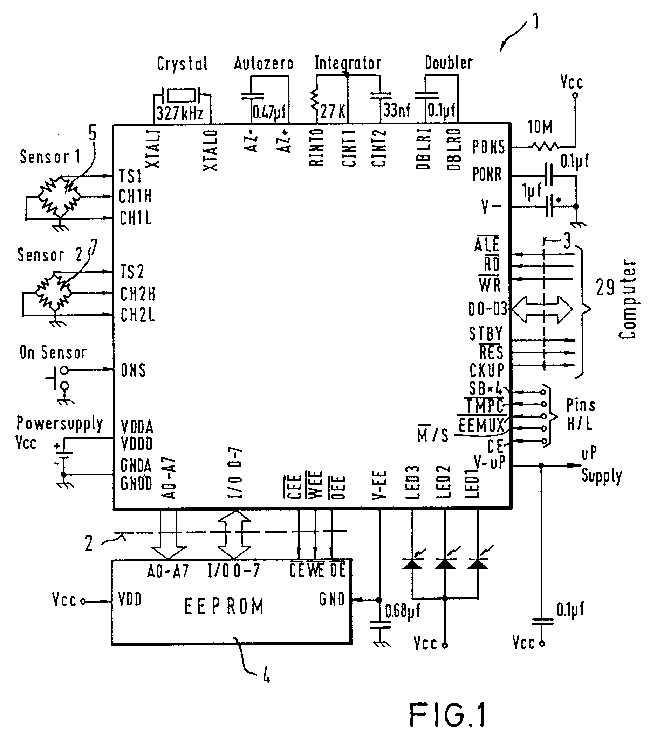

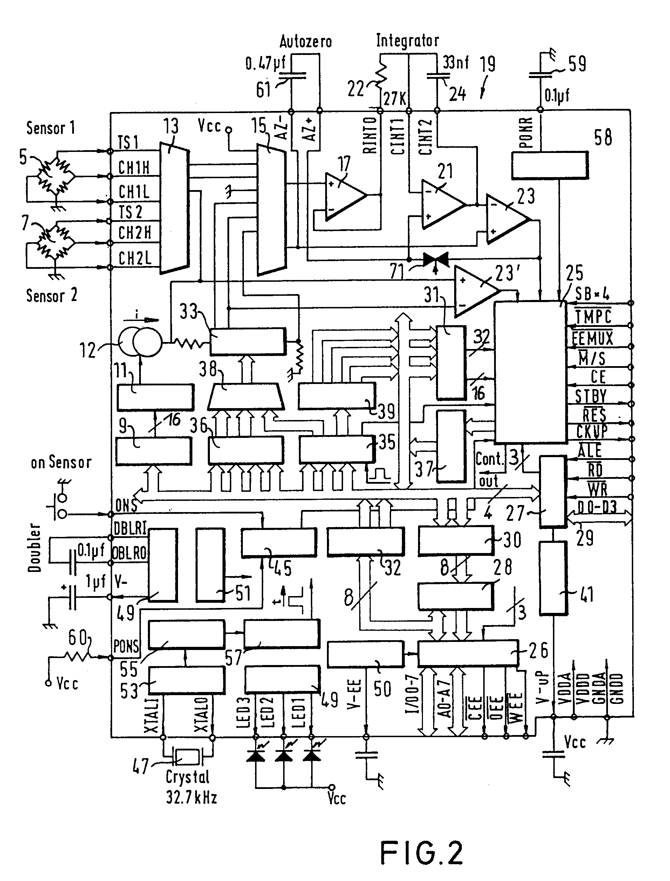

Nachfolgend wird insbesondere auf Figur 1 und 2 Bezug genommen, in denen ein prinzipielles Blockdiagramm mit den zugehörigen Anschlußdiagrammen gezeigt sind.

Die Vorrichtung besteht danach aus einer Signalverarbeitungsschaltung 1, die als Halbleiter-Chip ausgebildet ist. Hieran anschließbar ist über eine erste Schnittstelle 2 ein elektrischer lösch- und programmierbarer Festwertspeicher EEPROM 4. Die Signalverarbeitungs-Schaltung 1 ist ferner über eine weitere Schnittstelle 3 an einen externen Mikroprozessor oder Mikrobus anschließbar. Die in Fig.1 mittels Buchstaben- und/oder Zahlenkombinationen benannten Anschlüsse bzw. betätigbaren Schalter sind durch die in der Anlage wiedergegebene Tabelle erläutert und aufgelistet, auf die insoweit Bezug genommen wird.

Mit der in Figur 1 gezeigten Schaltung können zwei Sensoren 5 und 7 angeschlossen werden. Die Sensoren können alternativ, beispielsweise sogar auch verschachtelt und somit zeitversetzt simultan betrieben werden, z. B. bei einem Referenzdruckmesser.

Die Versorgungsspannung $V_{CC}$ liegt an Eingängen VDDA/VDDD sowie an dem Masseanschluß GNDA/GNDD an. Die Sensorbrücken-Strom-Speisung kann über einen Vierbit-Registerdekoder 9 und eine nachgeordnete Stromquellen-Wahlstufe 11 in 16 programmierbaren Einzelschritten eingestellt und vorgewählt werden, die über die innere Stromquelle 12 und einen ersten Multiplexer 13 wahlweise an die jeweilige Meßbrücke des ersten oder zweiten Sensors 5 bzw. 7 anlegbar ist. Diese 16 unterschiedlich programmierbaren Stromstufen werden auch genutzt, um den Sensor in einen Acht-Bit-Analog-Digitalbereich einzustellen, wenn durch Digital-/Analog-Vergleich an der Meßbrücke die Temperatur gemessen wird. Die programmierbare Stromquelle wird darüber hinaus auch zur Einstellung des Sensorsignales im Hinblick auf den gewünschten Ausgangs-Spannungsbereich benutzt. Ferner ist eine Temperaturkompensation möglich, die später erläutert wird. Wie allgemein üblich, werden die Spannungen am jeweiligen Sensor 5 bzw. 7 über die Anschlüsse TS1 bzw. TS2 (Top of Sensor) und dem gegenüberliegenden Masseanschluß an der Brücke angelegt. Das quer dazu an der Meßbrücke abgenommene Meßsignal wird über die Anschlüsse CH1H (Channel 1 High) und CH1L (Channel 1 Low) dem ersten Multiplexer 13 und über einen weiteren Multiplexer 15 einem Puffer 17 als Zwischenspeicher zugeführt. An dem Ausgang des Pufferspeichers 17 wird eine Integrator-Stufe 21 und daran die Komparatorstufe 23 zur Bildung eines Analog-Digital-Konverters 19,kurz auch ADC genannt, nachgeschaltet.

Nachfolgend wird der AD-Konverter beschrieben, der nach dem sog. Doppelintegrations-Verfahren (Dual Mode) arbeitet.

Zum grundsätzlichen Aufbau und zu der Funktionsweise eines derartigen AD-Konverters wird u. a. auf den allgemeinen Stand der Technik, insbesondere auf das Buch DE-B "Halbleiter-Schaltungstechnik" U. Tietze und C. Schenk, 5. Auflage, 1980, S. 649 beginnend, vor allem S. 658 bis 664 sowie auf das Buch "Digitale Schaltungen und Schaltkreise" Dr. Alfred Hüthig Verlag, Heidelberg, 1982, S. 431 bis 453 verwiesen, auf deren Offenbarungsgehalt in vollem Umfange Bezug genommen wird.

Wie daraus an sich bekannt ist, ist der Eingang des Integrators 21 über einen Eingangswiderstand 22 (im Ausführungsbeispiel 27 KOhm) mit dem Ausgang des Pufferspeichers 17 verbunden. Zwischen Eingang und Ausgang des OP-Verstärkers 21 ist noch ein Kondensator 24 (im Ausführungsbeispiel 33 nF) geschaltet. Der Ausgang des Integrators führt auf einen Komparator 23, dessen Ausgang mit einer Master-Steuerlogik 25, im folgenden auch kurz MCL genannt, verbunden ist. Auf die prinzipielle Arbeitsweise dieses AD-Konverters wird später noch eingegangen.

Da der weitere Aufbau der Signalverarbeitungs-Schaltung 1 nicht fest verdrahtet, sondern zur Erzielung einer großen Anpassungsbreite programmierbar aufgebaut ist, ist im gezeigten Ausführungsbeispiel ein vier-bit-breiter bidirektionaler Bus vorgesehen, wobei über Vier-Bit-Register die Bits zyklisch verschoben werden können.

Über einen Mikroprozessor-Anschluß 27 als Eingabe-Ausgabeanschluß ist über einen D0-D3-Kanal 29 eine Verbindung von dem internen Bus der Signalverarbeitungs-Schaltung 1 über die Schnittstelle 3 ein

4

Anschluß an einen externen Mikroprozessor oder eine externe Datenweiterverarbeitung möglich. Der Schnittstelle 3 ist auch der Adressregister-Freigabeimpuls ALE (ALE-STROBE), der Lese-Eingangsimpuls RD (Read Strobe) zum Bus-Lesen und der Schreibeingabeimpuls WR (Write Strobe) zum Bus-Schreiben zugeordnet. Über den ALE-Impuls wird der anstehende 4-Bit-Eingangswert vom DO-D3-Kanal 29 in den Adress-Speicher 31 eingelesen, welcher seinerseits über die MCL-Logic den gewählten D-Speicher zum nachfolgenden Schreiben oder Lesen aktiviert. Über den RD-Strobe-Impuls liegt das durch die entsprechende Aktivierung des D-Speichers an dessem Ausgang anstehende Ausgangssignal an dem DO-D3-Kanal 29 an. Als interne Logik sind in der Signalverarbeitungs-Schaltung 1 ferner zwei Vier-Bit-Instruktions-Register 31 vorgesehen. Diese Register werden mit einem Vier-Bit-Logikkontrollwort LCW beschrieben. Diese Vier-Bit-LCW-Worte werden dann durch zwei, 16 aus 4-Bit-Befehlswort-Dekodern dekodiert und in Ausgangssignale konvertiert, die einzelne Steuerblöcke der MCL-Master-Steuerlogik 25 schalten. Jedes LCW-Befehlswort bleibt unverändert anstehend, bis eine nächste Änderung eintritt.

Um im gezeigten Ausführungsbeispiel den AD-Konverter programmierbar betreiben zu können, ist ferner ein Acht-Bit-Digital/Analog-Konverter mit einer Widerstandskette zusätzlich zu der in 16 Schritten programmierbaren Spannungsversorgungswahlstufe 11 vorgesehen. Der DA-Konverter 33 wird nicht nur zur Temperaturmessung, sonderen dazu ergänzend auch zur Signal-Kompensation verwandt, nämlich einmal zur automatischen "Nullpunkt-Kompensation" und zur Grobeinstellung des vollen Skalenbereiches in der ersten Ruhe- und der positiven Flankenphase. Neben diesem Acht-Bit-DA-Konverter 33 wird ein zusätzlich programmierbarer ADC-Zähler 35 benutzt, um die Länge des Zeitsignales T während der Integration der negativen Flankenphase einzustellen, um darüber einen Fein-Vollskalenabgleich mit 12 Bits vorzunehmen. Dabei sind der ADC-Zähler 35 und zwei Acht-Bit-Register 36 zur Nullpunkt- und Empfindlichkeits-Grobeinstellung über drei Acht-Bit-Multiplexer 38 mit dem Eingang des DA-Konverters 33 verbunden.

Während der positiven Flankenphase wird der programmierbare Zwölf-Bit-Zähler 35 genutzt, um zwischen einer Acht-, Zehn- oder Zwölf-Bit-ADC-Auflösung zu wählen, indem der Takteingang nach Art eines Frequenzteilers verarbeitet und die Länge der positiven Flankenzeit gezählt wird, die einem binären Äquivalent zu dem A-D-konvertierten Sensorsignal entspricht. Während des Digital-Analog-Vergleiches des Temperatursignales der Meßbrücke wird der Zwölf-Bit-Zähler 35 dazu benutzt, um das Acht-Bit-Digital-Analog-Signal hinaufzutransformieren, bis der Komparator 23' bei Erreichen der Meßbrücken-Spannung den Zählvorgang über die MCL-Logic 35 abschaltet. Zu diesem Augenblick entspricht die Zählerposition dem Acht-Bit-binären Äquivalent der Temperatur.

Der weitere Ablauf der Schaltung erfolgt automatisch. Die Konversionszustandswerte werden dabei einem logischen Zustands-Ausgangsregister 37 eingeschrieben. Der Ausgang des erwähnten Zwölf-Bit-ADC-Zählers 35 wird in drei Vier-Bit-ADC-Ausgangsregister 39 übertragen. Danach werden alle ADC-Schaltkreise abgeschaltet, wobei alle entsprechenden ADC-Werte und ihre logischen Zustände durch Ablesen an besagten Ausgangs-Registern 37 und 39 zugänglich sind.

Zur Versorgung des EEPROM's 4 ist eine Fünf-Volt-Spannungsversorgung 50 vorgesehen, welche die Pegelanpassung des Schnittstellenbausteines 26 vorgibt. Der Lese- und Schreibvorgang des EEPROM 4 ist über LCWs, welche in das Instruktionsregister 31 geladen werden, und über den internen Bus der Signalverarbeitungs-Schaltung 1 betreibbar und angeschlossen. Das EEPROM umfaßt beispielsweise zwei interne Acht-Bit-Register. Jedes Register kann dabei beispielsweise zwei Satz von Vier-Bit-Registern umfassen, die über den Vier-Bitbus zugänglich sind. Durch Drücken des Stiftes EEMUX wird ermöglicht, daß die Adressen und Daten zu dem EEPROM 4 gemultiplext werden können. Da die Signalverarbeitungs-Schaltung 1 programmierbar aufgebaut ist, ist das externe EEPROM 4 über eine Schnittstellenkartei 26, einen Adress-Daten-Multiplexer 28, zwei 4-Bit-Eingangs- und 8-Bit-Ausgangsregister 30 und ein weiteres 8-Bit-Ein- sowie zwei 4-Bit-Ausgangsregister 32 mit dem internen Bus verbunden.

Schließlich kann auch noch der Kontrast einer LCD-Anzeige auch unabhängig von Temperatur- und Batterieschwankungen optimiert werden. Dazu ist eine Temperaturkompensation 41 für die Mikroprozessorschnittstelle 3 vorgesehen. Hierüber wird beispielsweise von -20° bis 70°C eine selbsttätige Anpassung vorgenommen, wozu die Temperaturkompensationsschaltung 41 einen Temperaturkoeffizienten von 14 mV/°C aufweist. Bei 25 °C ergibt sich beispielsweise eine 3 Volt Versorgung. Dazu müssen lediglich das externe Massepotential GMD sowie der Mikroprozessor LCD-Treiber usw. an den V-UP-Stift angeschlossen und der Stift TMPC hineingedrückt werden. Das Herausziehen des Stiftes TMPC bewirkt ein Abschalten des Temperatur-Kompensations-Schaltkreises.

Schließlich können auch mehrere LED-Treiberkreise 49 vorgesehen sein, um verschiedene LED's entsprechend verschiedener Funktion mit unterschiedlichen Blitzfrequenzen zu betätigen, auf die aber im folgenden nicht näher eingegangen wird.

Ferner ist noch ein Sensor-An-Schaltkreis 45 vorgesehen, der den anstehenden Wert am externen ONS-Stift mit einem internen 600 KOhm-Widerstand vergleicht. Jeder Widerstandswert unter 550 KOhm schaltet den Sensor-An-Schaltkreis 45 auf seinen Sollwert. Dieser Schaltkreis 45 kann programmierbar durch ein entsprechendes LCW-Befehlswort an- oder abgeschaltet werden. Durch Drücken des M/S-Stiftes wird die Signalverarbeitungs-Schaltung 1 im sog. Masterbetrieb betrieben. Darüber hinaus kann eine Umschaltung auf Niedrigleistung vorgenommen werden, bei der beispielsweise der Schaltkreis nur 0,5 µA verbraucht. Reaktiviert werden kann die Schaltung über den erwähnten Sensor-An-Schaltkreis 45. Ferner wird der Schwingquarz 47, kurz XTAL genannt, gestoppt und der Mikroprozessor-Massenanschluß und alle anderen Ausgänge auf Spannungsversorgungsniveau gesetzt, mit Ausnahme des Sensor-An-Schaltkreises 45, der aktiviert bleibt.

Bei einem Widerstand von weniger als 500 KOhm wird - wie erwähnt - der Schaltkreis 45 wieder aktiviert, so daß auch der Schwingkristall 47 wieder zu schwingen beginnt. Auch die anderen Änderungen werden wieder rückgängig gemacht.

Der Sensor-An-Schaltkreis 45 hat eine Hysterese von 50 KOhm. Hierdurch wird ein Anschalten durch Überbrücken des ONS-Stiftes und des GND-Stiftes (Masse-Stift) durch feuchte Finger oder bei Verwendung als Wassersensor ermöglicht.

In Figur 2 ist ein Spannungsverdoppler 49 gezeigt, über den eine negative entgegengsetzt zur Versorgungsspannung liegende Spannung erzeugt ist. Die Effektivität liegt bei 95° oder besser. Der negative Anschluß V-EE für die EEPROM-Versorgung nützt diese negative Spannung, um letztlich eine 5-Voltspannungsversorgung zwischen dem Plus- und Negativanschluß VDD und V-EE zu ermöglichen (EEPROM-Spannungsversorgung 50).

Ein Vorspannungsschaltkreis 51 umfaßt mehrere Stromspiegelschaltungen. Durch jeden Vorspannungskreis können alle während des Betriebes notwendigen Stromniveaus erzeugt und die groben Stromschritte zur Sensorversorgung durchgeführt werden.

Der bereits erwähnte Schwingquarz 47 ist über zwei Anschlüsse XTALI und XTALO an einem Schwingkreis 53 angeschlossen. In üblicher und an dieser Stelle nicht näher geschilderten Weise wird hierüber ein Abtastimpuls-Generator 55 und ein Taktfrequenzgenerator 57 angesteuert.

Ein externer geerdeter Kondensator 59 sorgt in Verbindung mit einem internen 1MOhm 60 (PONR-Kreis 58) für einen bestimmten Ausgangs zustand aller Register, Ausgänge interner logischer Kreise und der inneren Leistungsversorgung und entspricht der automatischen Reset-Funktion bei erstmaliger Spannungsbeaufschlagung.

Darüber hinaus ist - wie bereits erwähnt - eine Niedrigleistung-Schaltung möglich, bei der mit Ausnahme des Sensor-An- Schaltkreises 45 alles abgeschaltet ist und die Signalverarbeitungs-Schaltung 1 weniger als 1 µA Leistung verbraucht, in Abhängigkeit von dem mit dem PONS-Stift in Verbindung stehenden Widerstand 60. Ein Widerstand von 10 MOhm führt zu 0,6 µA, 20 MOhm zu 0,3 µA Stromverbrauch.

Schließlich sind noch unterschiedliche Betriebsweisen bei der Signalverarbeitungs- Schaltung 1 möglich, nämlich einmal der sog. Master- oder Slave-Betrieb . Die untergeordnete Slave-Betriebsweise wird durch Herausziehen des M/S-Stiftes ermöglicht. Über die Leitungen CE-Freigabe wird dann die Signalverarbeitungs-Schaltung 1 gesteuert . Solange der CE-Stift eingedrückt ist, verbleibt der Ausgangsbus D0-D3 29 in den drei Zuständen und reagiert nicht auf ALE-, RD- oder WR-Impulse. Durch Hintereinander- und Zusammenschaltung mehrerer Signalverarbeitungsschaltungen 1 kann dann die sog. Slave-Betriebsweise durchgeführt werden.

Durch Herausziehen des CE-Stiftes kann über die Mikrobus-Schnittstelle 3 der uneingeschränkte Betrieb vorgenommen werden. Der Master-Betrieb dient vor allem dazu, den Energieverbrauch eines Mikroprozessor-Instruments zu minimieren. Die beschriebene Vorrichtung schaltet dafür die Spannungsversorgung der übrigen Bauelemente auf Software-Kommando, wobei externe Schaltkreise zwischen der allgemeinen VDD-Stromversorgung und dem V-UP-Stift als allgemeines GND-Massepotential geschaltet werden. Der interne FET-Schalter für die Leistungsaussteuerung bei der V-UP-Spannungsversorgung hat einen internen On-Widerstand mit weniger als 100 Ohm und kann externe Schaltkreise bis zu 5 mA bei 3 V ansteuern.

Die sog. Master-Betriebsweise wird durch Niederdrücken des M/S-Stiftes und durch Herausziehen des CE-Stiftes ermöglicht.

Die Fehlerkompensation mit der vorstehend beschriebenen Signal-Verarbeitungs-Schaltung 1 erfolgt im wesentlichen in zwei Schritten.

Der erste Schritt betrifft die sog. Kalibrierphase, in der die entsprechenden Kompensations- und Signalverarbeitungswerte erfaßt und eingespeichert werden. Die zweite Phase betrifft dann die aktuelle Drucksignalmessung und -verarbeitung unter Berücksichtigung der Fehlerkompensation.

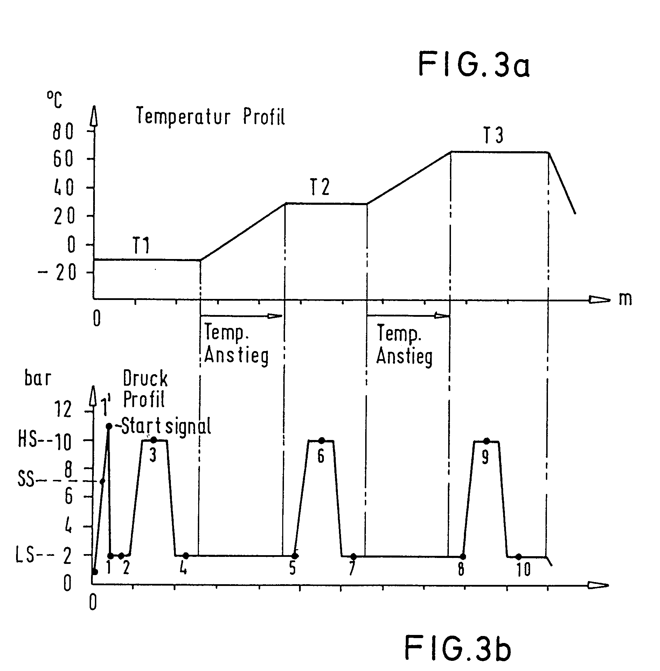

Unter Bezugnahme auf die Figuren 3a und 3b wird zunächst die Kalibrierphase erläutert.

Dazu wird die Meßschaltung mit dem angeschlossenen Sensor, beispielsweise dem ersten Sensor 5, einer Druck-Zeit-Kurve ausgesetzt, wie sie in Figur 3b dargestellt ist. Gleichzeitig wird eine Temperatur-Zeit-

EP 0 357 616 B1

Kurve durchfahren, wie sie in Figur 3a dargestellt ist. Natürlich sind auch andere Temperatur/Druck/Zeit-Profil-Kurven möglich, um z. B. auch Linearitätskorrekturen und Kurvenanpassungen vorzunehmen.

Bezug nehmend auf die Figuren 3a und 3b werden an den einzelnen Stellen 1 bis 10 folgende Werte erfaßt, verrechnet und als Einstellwerte eingespeichert, wobei über die Software sichergestellt ist, daß der Beginn der Kalibrier- und Eichphase bei "1" erkannt und die einzelnen Meßpunkte dann durch die Software gesteuert automatisch erfaßt und durchlaufen werden, um dann an den Stellen 0 bis 10 z. B. in einem EEPROM mit 31 x 8 Bit die entsprechenden Werte einzuschreiben, mit denen beispielsweise ein 10 bar Drucksignal mit einer 10-Bit-Auflösung (1 Bit = 0,01 bar oder 0,1 % des maximalen Skalensignales) kompensiert werden kann. Beim ersten, d.h. niedrigsten Temperaturniveau wird zunächst der Strom eingestellt, und zwar bei "0" in Figur 3b. Nach Erkennen des Startsignales SS, welches spätestens an der Stelle "1'" erkannt wird, wird dann bei "1" die erste Temperatur gemessen und gespeichert. Darauf erfolgt bei "2" die Offset-Grobsignaleinstellung und Abspeicherung. Dann wird bei erhöhtem Druck HS auf das gewünschte Vollskalen-Grobsignal FS eingestellt und dessen Einstellparameter zur Temperatur T1 gespeichert. Von da an erfolgt periodisch bei dieser und allen weiteren Temperaturen eine FS-Feinjustierung ("3", "6", "9"), wobei bei den folgenden Temperaturen jeweils bei niedrigem Druckniveau LS ("5", "8") die Temperatur gemessen und eingespeichert, bei nachfolgendem hohen Druckniveau HS für die jeweils zugehörige Temperatur die Vollskalen-Feinjustierung FS vorgenommen und eingespeichert und anschließend wieder bei niedrigem Druckniveau LS ("4", "7", "10") der Offset-Druck gemessen und eingespeichert wird.

Die Schaltung wird den unterschiedlichen benötigten Temperatur- und Druckwerten ausgesetzt, wobei die Profilabfolge für Temperatur und Druck als Normwerte im Mikroprozessorprogramm vorgegeben sein müssen, so daß das Programm dem Eichprofil folgen kann.

Der Vorteil in diesem Zusammenhang liegt auch darin begründet, daß für die Temperaturkompensation für die Meßbrücke kein separater Temperatursensor benötigt wird. Es wird lediglich die Brückenspeisespannung gemessen, die der Temperatur äquivalent ist. Wie aus dem geschilderten Profil ersichtlich ist, können beispielsweise für drei Temperaturen die entsprechenden Werte festgestellt und gespeichert werden, wobei die dazwischen liegenden Temperaturen bzw. Temperaturkompensationswerte durch Interpolation ermittelbar sind.

Ferner ist eine Speisespannungskompensation vorgesehen. Während des Betriebes der Vorrichtung wäre es ja möglich, daß aus welchen Gründen auch immer, die Speisespannung schwankt. Derartige Schwankungen der Speisespannungsversorgung würden aber eine entsprechende Verfälschung der Meßergebnisse verursachen. Von daher bewirkt die automatische Versorgungsspannungskompensation, daß Spannungsschwankungen von bis zu ± 1 Volt automatisch durch den IC kompensiert werden. Eine noch größere Spannungsfluktuaton könnte analog zur Temperaturkompensation kompensiert werden.

Dazu ist an dem zweiten Multiplexer 15 sowohl ein Eingang $V_{CC}$ als auch ein Masse-Anschluß vorgesehen. Die Kompensation erfolgt analog zur Temperaturkompensation, wobei die Speisespannung während der Kalibrierphase in binäre Äquivalente umgesetzt und dann während der Meßphase rechnerisch beispielsweise durch Interpolation zur Erzielung der Kompensation mitberücksichtigt wird.

Nachdem die entsprechenden Eich-Kompensations- und Signalverarbeitungswerte in dem EEPROM 4 abgespeichert sind, kann mit der Signalverarbeitungsschaltung 1 eine Druckmessung und entsprechende Drucksignalverarbeitung vorgenommen werden. Dabei erfolgt die Signalkompensation und Signalverarbeitung während der Digitalisierung des analogen Meßsignals.

Die Signalkompensation und Signalformung wird dabei bei dem Analog-Digital-Konverter 19 in drei Phasen vorgenommen.

In der ersten, der sog. Nullpunkt- oder Ruhephase werden nicht nur innere Spannungsverschiebungen, Langzeit-Unstabilitäten oder andere Fehler oder Abweichungen interner Schaltkreise korrigiert, sondern vor allem der Startpunkt des Integrators auf einen zuvor gemessenen und programmierten Spannungslevel gehoben, wodurch die Sensor-Brückenabweichspannung ($S_0$) eleminiert wird. Die geeignete positive oder negative Kompensationsspannung wird mittels eines Programmes durch den internen Acht-Bit-DAC 33 erzeugt. Bevor die zweite Phase gestartet wird, wird die Summe aller Abweichungen in den automatischen Nullpunkt-Korrektur-Kondensator 61 geladen und liegt somit an dem positiven Eingang des ADC-Integrators 21 als virtuelle Nullpunktspannung $U_z$ an. Ergänzend wird dabei noch angemerkt, daß ein Umschalter 71, der zwischen dem Plus-Eingang des Integrators 21 und dem Ausgang des Komparators 23 geschaltet ist, benötigt wird, um den Integrator 21 in der ersten Phase auf "null" zu setzen. Dazu ist die vorstehend erwähnte Verbindungsleitung zwischen auf/zu mittels des Umschalters 71 umschaltbar. Während der ersten Integrationsphase steht dabei der Schalter auf "zu", während bei der nachfolgenden Integrationsphase auf "auf" geschaltet wird.

7

EP 0 357 616 B1

In der zweiten Phase, d. h der Phase mit einer negativen Flanke wird nunmehr die Spannungsdifferenz $U_e$ zwischen dem unbekannten Sensor-Eingangssignal $S_e$ und dem Sensor-Brückenabweichsignal $S_0$ für eine vorprogrammierte Zeitlänge T integriert. Die geeignete Zeitlänge T wird durch den programmierbaren Zwölf-Bit-Zähler 35 erzeugt. Wenn z. B. der Zwölf-Bit-Zähler 35 durch ein Zehn-Bit-Wort festgelegt wird, so wird dadurch eine negativen Flankenphase mit einer Zeitlängen-Variation zwischen 4.096 und 3.072 Taktperioden möglich. Dadurch wird der Zählzyklus N variiert.

Die Programmierung der Zeitlänge der negativen Phasenflanke ist gleichbedeutend mit einer Feinabstimmung des vollen Skalenbereiches, in dem 25 % (bei diesem Ausführungsbeispiel) der maximalen negativen Phasenlänge eingestellt und verändert wird.

An die zweite Phase schließt sich die dritte Phase mit positiver Flanke an, deren Länge variabel ist. Hierbei liegt am Eingang des Integrators 21 anstelle der Sensor-Eingangssignal-Differenz $U_e$ wieder eine Referenzspannung $U_r$ an. Die positive Phasenlänge hängt von der Größe des im Skalenbereich voreingestellten vorintegrierten Spannungsdifferenzsignal zwischen dem Sensorsignal und dem Sensor-Abweichsignal ab ($U_e = S_e - S_0$). Die variable positive Flankenphase bestimmt das endgültige ADC-Ausgangssignal auch im Hinblick auf eine Grobeinstellung des Skalenbereiches zur Einstellung eines gewünschten Meßbereiches.

Während dieser positiven Flankenphase wird die vorprogrammierte Referenzspannung $U_r$ entgegengesetzter Polarität zu der Eingangsspannung $U_e$ aufwärts integriert. Die geeignete Referenzspannung $U_r$ wird unter der Kontrolle des Programmes über den internen Acht-Bit-DAC 33 erzeugt und automatisch in den + Eingang des Integrators während der positiven Phase angelegt.

Über den Komparator 23 wird der interne Zähler gestoppt, wenn der Ausgang des Integrators die virtuelle Nullspannung $U_z$ wieder erreicht. Der Zählerausgang wird in das ADC-Ausgangs-Register 39 eingelesen und das End-Konversion-Signal (CC-Conversion Complete) abgegeben. Sollte der Zähler 100 % des vorprogrammierten vollen Skalenbereiches (maximale Taktperiodenzahl) erreichen, bevor der Integrator $U_z$ erreicht, dann wird das Konversion-Überlauf-Signal COV (Conversion Overflow) erzeugt und die Integration gestoppt. Die COV- und CC-Signale sind aus dem Zustandsausgangregister 39 abrufbar. An dem Zustandsausgangsregister 39 liegt auch der Status des ON-Sensor-Signals an, welches aus dem Zustandsausgangsregister 39 auch abrufbar ist.

Da die Signalanpassung und Signal-Skalenbereichseinstellung iterative Funktionen sind, muß das letztlich erhaltene ADC-Signal einer mathematischen Anpassung unterzogen werden, bevor es als binäres Sensorausgangssignal verarbeitet werden kann.

$$CLCADC = (ADCOUT - OFSSRD) * \frac{HS - LS}{FS - OS} + LS$$

Die vorstehend genannten Abkürzungen bedeuten dabei

CLCADC : berechneter ADC-Wert
ADCOUT : ADC-Ausgabewert
HS : nominaler High-Signal-Eingabewert
LS : nominaler Low-Signal-Eingabewert
FS : Nennwert für den ADC-Ausgang bei FS (nominaler Voll-Skalen-Wert)
OS : Nennwert für ADC-Ausgang bei LS (nominaler Wert für die Offset-Überprüfung)
OFSSRD : ADC-Ausgabewert bei LS (Offset-Signal-Ausgabe zur mathematischen Adaption).

Die Umrechnung ist denkbar einfach, da es sich dabei doch lediglich um die Bestimmung einer Geradengleichung handelt.

Aus dem geschilderten Aufbau und der Arbeitsweise wird deutlich, daß die Signalverarbeitungs-Schaltung 1 allein durch eine Programmänderung an die unterschiedlichsten, vielfältigsten Aufgaben anpaßbar ist. Durch die Signalverarbeitung und -kompensation während der Analog-Digital-Umsetzung wird eine bisher ungeahnte Genauigkeit bei minimalem Energieaufwand für die Signalformung erreicht. Durch die Verwendung eines internen Busaufbaus kann zudem eine problemlsoe weitere Signalverarbeitung über einen externen, an einer Schnittstelle anschließbaren Mikroprozessor oder Mikro-Bus erfolgen.

In Figur 2 ist durch an Querstrichen hinzugefügten Zahlen die Anzahl der getrennten Leitungen bzw. bei einem Bus die Anzahl der den Bus umfassenden Leitungen angegeben.

8

EP 0 357 616 B1

## Tabelle der Anschluß-Kurzbezeichnungen:

| | |
|---|---|
| GNDA | Massenpotential (GND) des Ananlogkreises |
| GNDD | Massenpotential (GND) des Digitalkreises |
| VDDA | Hauptstromversorgung für den Analogkreis |
| VDDD | Hauptstromversorgung für den Digitalkreis |
| V- | Minus VDD Ausgang, an dem der Spannungs-doppler-Schaltkreis anliegt (verbindet 1µF mit GND) |
| V-EE | Negativer Spannungsversorgungsausgang des EEPROM's. Verbindung des GND-Steckers des EEPROM's und 1µF mit GND-Potential an diesem Stecker. Alle EEPROM-Verbindungen sind auf V-EE bei L und VDDD bei H niveauverschoben, wenn sie gebraucht werden. |
| V-UP | Mikroprozessor-GND-Potentialausgang. Verbindet den GND-Ausgang des Mikroprozessors oder anderer leistungsgesteuerter Schaltkreise mit 0,1 µF mit der Hauptstromversorgung an diesem Stecker. Wenn TMPC = H, dann arbeiten alle Mikroprozessor-Verbindungen und deren Schnittstelle auf GND-Potential und bei TMPC = L auf dem negativen niveauverschobenen virtuellen GND-Potential. |
| DO-D3 (BUS) | Wahrer bidirektionaler Mikroprozessor-Anschluß zum gleichzeitigen Schreiben oder Lesen mittels RD-, WR- bzw. ALE-Strobe-Impuls. Die Steuerung erfolgt über die negative Flanke des RD-, WR- oder ALE-Strobe-Impulses, Daten, Kommandos und Registeradresse zum und vom Bus. |
| RD | Anschluß zum Lesen des Strobe-Impulses zum Bus-Einlesen |
| WR | Anschluß des Schreib-Strobe-Impulses zum Bus-Einlesen |
| ALE | Adress-Latch-Enable-Eingang. Dieses Signal erscheint während jedes Zyklusses der Adressierung der internen Register der Elektronikvorrichtung. |
| CKUP | Taktausgang (Clock) zum Betrieb und zur Synchronisation des Mikroprozessors. |

9

| | |
|---|---|
| STBY | Standby Strobe-Ausgang für die Standby-Schaltung des Mikroprozessors (act.H) und zur Freigabe nach einer vorgewählten Zeit. Die Länge wird durch die Wahl des SB*4 und durch die Taktfrequenz gesteuert. |
| RES | Reset Strobe-Ausgang, um den Mikroprozessor zu reseten (act.L) und erneut zu starten. |
| SB*4 | Standby Länge *4, Eingangsstift (act.H). Zum Beispiel: bei 32,7 kHz Taktfrequenz, SB*4 = H → Standby-Länge = 2s. SB* = L → 0,5s. |
| TMPC | Eingangsstift für eine wahlweise temperatur-kompensierte Mikroprozessor-Schnittstelle (act.L). |
| EEMUX | Eingangsstift für die wahlweise Multiplex-EEPROM-Daten/Adress-Schnittstelle. (act.L.) |
| M/S | Eingangsstift zur wahlweisen Umschaltung Master/Slave-Mode (M/S: = L → Master-Betrieb, sonst Slave-Betrieb). |
| CE | wahlweiser Eingangsstift für Chip Enable (act.H). |
| ONS | On-Sensor Eingangsstift, Niedrig-Impedanz-Eingangsverstärker, On-Signal liegt an, wenn durch externe Berührung der Widerstand < als 550 kohm ist. |
| TS1-TS2 | Meßbrückenverbindungsstift des Sensors 1 und 2 |
| CH1H-CH2H | Sensor-Kanal 1 und 2 für High-Signal-IN |
| CH1L-CH2L | Sensorkanal 1 und 2 für Low-Signal-IN |
| DBLRI DBLRO | Doppler-Eingangsstift verbindet 0,µF mit DBLRO Doppler-Ausgangsstift |
| AZ+ AZ− | automatische Nullpunktbestimmung +Eingangsstift, verbindet 0,47µF mit AZ− automatische Nullpunktbestimmung −Eingangsstift |
| RINTO CINT1 | RO-Integrator-Eingangsstift, verbindet 47 kohm mit CINT1, C1-Integrator-Eingangsstift, verbindet 0,033 µF mit CINT2 |
| CINT2 | C2-Integrator-Ausgangsstift |

| XTALI | Kristall–Eingangsstift für den internen Oszillator. Auch Eingang für externen Taktgenerator. |
|---|---|
| XTALO | Andere Seite des Kristallsteckers |
| PONS | Leistungs-Einsparungs-Eingangsstift. Verbindet 10 bis 20 Mohm mit der Hauptleistungsversorgung (VDDD) für eine maximale Leistungseinsparung während der Leistungs-Niedrig-Betriebsweise. |
| PONR | Reset-Eingangsstecker für die Stromversorgungs-Zuschaltung. Verbindet 0,1µF mit dem GND-Potential den richtigen Schaltkreis-Reset zu Beginn der Leistungszuschaltung. |
| LED1–LED3 | LED-Treiber-Ausgangsstifte für erstes, zweites und drittes LED. Verbindet jeden Stecker eines LED mit dem GND-Potential. |
| A0–A7 | 8-Bit-EEPROM Adress-Anschluß für Adressregister zum externen EEPROM. |
| I/O0–I/O7 | Bidirektionaler Acht-Bit-EEPROM-I/O-Anschluß zum Daten-Schreiben und -Lesen. Wenn EEMUX = L, dann können Daten und Adressen gemultiplext gesandt werden. |
| CEE | Chip-Enable-Ausgangsstecker, wird als CE-Strobe-Impuls zum externen EEPROM benutzt. |
| WEE | Schreib-Enable-Ausgangsstecker, wird als WE-Strobe-Impuls zum externen EEPROM benutzt. |
| OEE | Ausgangs-Enable-Stecker, wird als RD oder OE-Strobe-Impuls zum externen EEPROM benutzt. |

## Patentansprüche

1. Verfahren zur Kompensation und/oder Formung externer Meßsignale mittels eines im Dual-Slope-Verfahren betreibbaren Analog-Digital-Konverters (19) mit einem Integrator (21) und einem nachfolgenden Komparator (23) mit den folgenden Merkmalen

   - es wird eine vorwählbare Nullpunktkompensation für Abweichungen interner Schaltkreise und für Abweichspannungen externer Meßsignale durchgeführt,
   - es werden unterschiedliche Referenzspannungen vorwählbar eingestellt,
   - es wird die Integrationsdauer für die Integration eines externen analogen Meßsignals festgelegt,
   - das Signal zur Nullpunktkompensation wird dabei an den einen Eingang des Integrators (21) und das analoge Meßsignal sowie zeitlich dazu versetzt das Referenzspannungs-Signal an den anderen Eingang des Integrators (21) angelegt,
   - die Signalkompensation und/oder -formung wird vorprogrammiert und mikroprozessorgesteuert durchgeführt,
   - die Signalkompensation und/oder Formungsdaten werden in digitalisierter Form aus einem Datenspeicher (4) ausgelesen oder über eine Schnittstelle (3,29) extern zugeführt,
   - die digitalisierten Nullpunktkompensations-Werte werden in ein die Eingangsspannungsdifferenz zwischen den beiden Eingängen des Integrators (21) veränderndes analoges Spannungssignal und die digitalisierten Referenzspannungswerte in eine analoge Referenzspannung umgesetzt, und

- ein programmierbarer Zähler (35) wird so voreingestellt, daß darüber die unterschiedlich vorwählbare Integrationsdauer für die zweite, eine Integration des Meßsignals bewirkende Phase des
Analog-Digital-Konverters (19) eingestellt wird.

2. Verfahren nach Anspruch 1, **dadurch gekennzeichnet**, daß vor der Analogisierung der digitalisierten
Nullpunktkompensationswerte sowie zur Erzeugung der vorwählbaren Referenzspannung die entsprechenden digitalisierten Daten zwischengespeichert werden.

3. Verfahren nach Anspruch 1 oder 2, **dadurch gekennzeichnet**, daß die digitalisierten Nullpunktkompensationswerte sowie die digitalisierten Referenzspannungs-Werte im Multiplexverfahren zu einem
Digital-Analog-Konverter (33) übertragen werden, mittels dessen sie analogisiert werden.

4. Verfahren nach einem der Ansprüche 1 bis 3, **dadurch gekennzeichnet**, daß ein analogisiertes
Nullpunktkompensations-Spannungssignal in einen Kondensator (24) geladen wird, welcher an dem
zum Meßsignaleingang zweiten Eingang des Analog-Digital-Konverters (19) angeschlossen ist.

5. Verfahren nach einem der Ansprüche 1 bis 4, **dadurch gekennzeichnet**, daß eine Skalenbereichs-
Abstimmung bezüglich des zu messenden analogen Meßsignals vorgenommen wird, und zwar nach
der Formel

$$CLCADC = (ADCOUT - OFSSRD)\ \frac{HS - LS}{FS - OS} + LS$$

wobei die Abkürzungen
CLCADC:      berechneter ADC-Wert (Analog-Digital-Konverter-Wert)
ADCOUT:      ADC-Ausgabewert
HS:          nominaler High-Signal-Eingabewert
LS:          nominaler Low-Signal-Eingabewert
FS:          Nennwert für den ADC-Ausgang bei FS (nominaler Voll-Skalen-Wert)
OS:          Nennwert für ADC-Ausgang bei LS
OFSSRD:      ADC-Ausgabewert bei LS
bedeuten.

6. Vorrichtung zur Signalkompensation und/oder -formung nach mindestens einem der Ansprüche 1 bis 5
mittels eines im Dual-Slope-Verfahren betreibbaren Analog-Digital-Konverters (19), mit den folgenden
Merkmalen
- es ist ein Integrator (21) und ein nachgeordneter Komparator (23) vorgesehen,
- es ist eine Einrichtung zur vorwählbaren Nullpunktkompensation für Abweichungen interner
Schaltkreise und für Abweichspannungen des externen Meßsignals vorgesehen, wobei an den
einen Eingang des Integrators (21) das Signal zur Nullpunktkompensation und an den anderen
Eingang das analoge Meßsignal sowie zeitlich dazu versetzt das Referenzspannungs-Signal
anlegbar ist,
- es ist eine Einrichtung zur vorwählbaren Einstellung einer unterschiedlichen Referenzspannung
und ein Zähler zur Festlegung einer Integrationsdauer während der Integration eines externen
analogen Meßsignals vorgesehen,
- die Einrichtung zur Signalkompensation und/oder -formung ist programmierbar und mikroprozessorgesteuert aufgebaut,
- die Signalkompensations- und/oder -formungsdaten sind in digitalisierter Form aus einem Datenspeicher (4) oder über eine Schnittstelle (3, 29) extern zuführbar,
- dem einen Eingang des Integrators (19) ist eine Digital-Analog-Konverter-Schaltung (33) vorgeschaltet,
- mittels der Digital-Analog-Konverter-Schaltung (33) sind die digitalisierten Nullpunktkompensations-Werte in das die Eingangsspannungsdifferenz zwischen den beiden Eingängen des Integrators/Analog-Digital-Konverters (19, 21) verändernds analoges Spannungssignal und die unterschiedlich einstellbare Referenzspannung in eine analoge Referenzspannung umsetzbar, und

12

- ein programmierbarer Zähler (35) ist vorgesehen, mittels dessen die Integrationsdauer des Analog-Digital-Konverters für die zweite, eine Integration des Meßsignals bewirkende Phase unterschiedlich vorwählbar einstellbar ist.

7. Vorrichtung nach Anspruch 6, **dadurch gekennzeichnet**, daß dem zum Meßeingang komplementären zweiten Eingang des Integrators (19) ein Kondensator vorgeschaltet ist, der mit der analogen Nullpunktkompensationsspannung ladbar ist.

8. Vorrichtung nach Anspruch 6 oder 7, **dadurch gekennzeichnet**, daß dem Digital-Analog-Konverter (33) ein Zwischenspeicher (36) zur Zwischenspeicherung der digitalisierten Nullpunktkompensations-Werte vorgeordnet ist.

9. Vorrichtung nach einem der Ansprüche 6 bis 8, **dadurch gekennzeichnet**, daß dem Digital-Analog-Konverter (33) ein Zwischenspeicher (36) zur Zwischenspeicherung der digitalisierten Referenzspannungs-Werte vorgeschaltet ist.

10. Vorrichtung nach einem der Ansprüche 8 oder 9, **dadurch gekennzeichnet**, daß zwischen dem Zwischenspeicher (36) und dem Digital-Analog-Konverter (33) zur Übertragung der in dem Zwischenspeicher (36) gespeicherten digitalisierten Nullpunktkompensations- sowie Referenzspannungs-Werte ein Multiplexer (38) geschaltet ist.

11. Vorrichtung nach Anspruch 10, **dadurch gekennzeichnet**, daß nur ein Digital-Analog-Konverter (33) vorgesehen ist, dem der Multiplexer (38) vorgeschaltet ist.

12. Vorrichtung nach einem der Ansprüche 6 bis 11, **dadurch gekennzeichnet**, daß der Kompensations-, Korrektur- bzw. Signalformungs-Wert in einem elektrisch lösch- und programmierbaren Festwertspeicher (EEPROM 4) abspeicherbar ist, welcher vorzugsweise über eine Schnittstelle (2) anschließbar ist.

13. Vorrichtung nach einem der Ansprüche 6 bis 11, **dadurch gekennzeichnet**, daß die Kompensations-, Korrektur- bzw. Signalformungs-Werte in einem elektrisch lösch- und programmierbaren Festwertspeicher (EEPROM 4) abspeicherbar sind, welcher auf der Halbleiterplatine der Vorrichtung integriert ist.

14. Vorrichtung nach einem der Ansprüche 6 bis 13, **dadurch gekennzeichnet**, daß in einem elektrisch lösch- und programmierbaren Festwertspeicher (EEPROM 4) die mittels einer den Temperaturwerten äquivalenten Brücken-Speisespannung meßbaren und durch Interpolation errechenbaren Temperaturkompensationswerte abspeicherbar sind.

15. Vorrichtung nach einem der Ansprüche 6 bis 14, **dadurch gekennzeichnet**, daß ferner eine Versorgungs-Spannungs-Kompensation vorgesehen ist, über welche die durch Spannungsschwankungen verursachten Signalverfälschungen kompensierbar sind.

16. Vorrichtung nach einem der Ansprüche 6 bis 15, **dadurch gekennzeichnet**, daß eine programmierbare Stromquelle zur Stromversorgung und Bereichswahl eines anschließbaren Sensors (5, 7) vorgesehen ist.

## Claims

1. Method for the compensation and/or shaping of external measured signals using an analog-to-digital converter (19) operating in a dual-slope method with an integrator (21) followed by a comparator (23) and having the following features
   - a preselectable zero-compensation for deviations of internal circuits and for deviating voltages of external measured signals is carried out,
   - preselectable reference voltages are set,
   - the integration time for integration of an external analog measured signal is established,
   - the signal for zero-compensation is thereby applied to the one input of the integrator (21) and the analog measured signal as well as the reference voltage signal displaced therefrom in time applied to the other input of the integrator (21),
   - the signal compensation and/or shaping is preprogrammed and microprocessor-controlled,

13

- the signal compensation and/or shaping data is read out in digitized form from a data store (4) or fed in externally via an interface (3, 29),
- the digitized zero-compensation values are converted to an analog voltage signal varying by the input voltage difference between the two inputs of the integrator (21) and the digitized reference voltage values converted to an analog reference voltage, and
- a programmable counter (35) is preset so that thereupon the variously preselectable integration time is set for the second phase of the analog-to-digital converter (13) producing an integration of the measured signal.

2. Method according to Claim 1, characterized in that prior to analogization of the digitized zero-compensation values as well as to generate the preselectable reference voltage, the corresponding digitized data is buffer stored.

3. Method according to Claim 1 or 2, characterized in that the digitized zero-compensation values as well as the digitized reference voltage values are transferred using the multiplex procedure to a digital-to-analog converter with which it is analogized.

4. Method according to any one of Claims 1 to 3, characterized in that an analogized zero compensation voltage signal is loaded into a capacitor (24), which is connected to the second input to the measured signal input of the analog-to-digital converter (19).

5. Method according to any one of Claims 1 to 4, characterized in that a scale range calibration is carried out with respect to the analog measured signal to be measured using the equation

$$CLCADC=(ADCOUT-OFSSRD)\ \frac{HS-LS}{FS-OS}\ +\ LS$$

wherein the abbreviations have the following meanings:

CLCADC:  Calculated ADC value (analog-to-digital converter value)
ADCOUT:  ADC output value
HS:  Nominal high-signal input value
LS:  Nominal low-signal input value
FS:  Nominal value for the ADC output with FS (nominal full-scale value)
OS:  Nominal value for ADC output with LS
OFSSRD:  ADC output value with LS.

6. Device for signal compensation and/or shaping according to at least any one of Claims 1 to 5 of an analog-digital converter (19) capable of being operated in the dual-slope method, with the following features:
- an integrator (21) following by a comparator (23) is envisaged,
- means for preselectable zero-compensation for deviations of internal circuits and for deviating voltages of the external measured signal are provided, wherein there can be applied to one input of the integrator (21) the signal for zero-compensation and to the other input the analog measured signal as well as the reference voltage signal displaced in time with respect to these,
- means for the preselectable setting of a varying reference voltage and a counter for establishing an integration time during integration of an external analog measured signal are provided,
- the means for signal compensation and/or shaping are designed to be programmable and microprocessor controlled,
- the signal compensation and/or shaping data can be input externally from a data storage device (4) or via an interface (3, 29),
- a digital-to-analog converter circuit (33) is connected in front of the one input of the integrator (19),
- the digitized zero-compensation values can be converted by means of the digital-to-analog converter circuit (33) into the analog voltage signal changing by the input voltage difference between the two inputs of the integrator/analog-to-digital converter (19, 21) and the reference

14

voltage with varying adjustment converted into an analog reference voltage, and

- a programmable counter (35) is provided, by means of which the integration time of the analog-to-digital converter for the second phase producing an integration of the measured signal can be set with variable presettings.

7. Device according to Claim 6, characterized in that a capacitor is connected in front of the second input of the integrator (19) complementary to the measuring input, and which can be loaded with the analog zero-compensation voltage.

8. Device according to Claim 6 or 7, characterized in that a buffer storage device (36) is arranged in front of the digital-to-analog converter (33) for the buffer storage device of the Zero-compensation values.

9. Device according to any one of Claims 6 to 8, characterized in that a buffer storage device (36) is connected in front of the digital-to-analog converter (33) for the buffer storage of the digitized reference-voltage values.

10. Device according to any one of Claims 8 or 9, characterized in that a multiplexer (38) is connected between the buffer storage device (36) and the digital-to-analog converter (33) for the transfer of the digitized zero-compensation and reference-voltage values stored in the buffer storage device (36).

11. Device according to Claim 10, characterized in that only one digital-to-analog converter (33) is provided to which the multiplexer (38) is series-connected.

12. Device according to any one of Claims 6 to 11, characterized in that the compensation, correction or signal-shaping value can be stored in a read-only memory (EEPROM 4) capable of being electrically deleted and programmed, which is preferentially connected via an interface (2).

13. Device according to any one of Claims 6 to 11, characterized in that the compensation, correction or signal-shaping value can be stored in a read-only memory (EEPROM 4) capable of being electrically deleted and programmed, which is integrated on the semiconductor printed-circuit board of the device.

14. Device according to any one of Claims 6 to 13, characterized in that measurable temperature-compensation values capable of being calculated by interpolation can be stored in a read-only memory (EEPROM 4) capable of being electrically deleted and programmed.

15. Device according to any one of Claims 6 to 14, characterized in that additionally a supply voltage compensation is provided by means of which the signal corruptions caused by voltage fluctuationS can be compensated.

16. Device according to any one of Claims 6 to 15, characterized in that a programmable power source for the power supply and range selection of a connectable sensor (5, 7) is provided.

**Revendications**

1. Procédé de compensation et/ou de formation de signaux de mesure externes au moyen d un convertisseur analogique-numérique (19) pouvant fonctionner suivant une méthode Dual-Slope avec un intégrateur (21) et un comparateur (23) situé en aval, qui présente les caractéristiques suivantes:
   - on effectue une compensation de zéro présélectionnable pour les anomalies des circuits de commutation interne et pour les anomalies de tension des signaux de mesure externes,
   - on adopte, de manière présélectionnable, différentes tensions de référence,
   - on détermine la durée d'intégration pour l'intégration d'un signal de mesure analogique externe,
   - on applique le signal de compensation du zéro à une entrée de l'intégrateur (21) et le signal de mesure analogique ainsi qu'un signal de tension de référence décalé dans le temps à l'autre entrée de l'intégrateur (21),
   - on extrait les données de compensation et/ou de formation de signaux sous forme numérisée d'une mémoire de données (4) ou on les introduits de l'extérieur par l'intermédiaire d'une interface (3, 29),

15

- on transforme les valeurs de compensation du zéro numérisées en un signal de tension analogique modifiant la différence de tension d'entrée entre les deux entrées de l'intégrateur (21) et les valeurs de tension de référence numérisées en une tension de référence analogique, et,
- on règle d'avance un compteur programmable (35) de façon que la durée d'intégration présélectionnable de manière différente pour la deuxième phase du convertisseur analogique/numérique (19) provoquant une intégration du signal de mesure.

2. Procédé selon la revendication 1, caractérisé en ce que, avant la transformation en valeur analogique des valeurs de compensation du zéro numérisées ainsi que pour créer la tension de référence présélectionnable, on met dans une mémoire intermédiaire les données numérisées correspondantes.

3. Procédé selon la revendication 1 ou 2, caractérisé en ce que l'on transmet les valeurs de compensation du zéro numérisées ainsi que les valeurs de tension de référence numérisées par un procédé de multiplexage à un convertisseur numérique-analogique (33), au moyen duquel ces valeurs sont mises sous forme analogique.

4. Procédé selon l'une des revendications 1 à 3, caractérisé en ce qu'on introduit un signal de tension de compensation de zéro sous forme analogique, dans un condensateur (24) qui est raccordé à la deuxième entrée du convertisseur analogique-numérique (19) servant d'entrée du signal de mesure.

5. Procédé selon les revendications 1 à 4, caractérisé en ce qu'on effectue une adaptation de l'intervalle d'échelle relative au signal de mesure analogique à mesurer suivant la formule

$$CLCADC = (ADCOUT - OFSSRD) \; \frac{HS - LS}{FS - OS} + LS$$

dans laquelle les abréviations ont les significations suivantes:
CLCADC:      valeur ADC calculée (valeur du convertisseur analogique-numérique)
ADCOUT:      valeur de sortie ADC
HS:          valeur nominale d'entrée du signal haut
LS:          valeur nominale d'entrée du signal bas
FS:          valeur nominale pour la sortie ADC pour FS (valeur nominale à fond d'échelle)
OS:          valeur nominale de la sortie ADC pour LS
OFSSRD:      valeur de sortie ADC pour LS

6. Dispositif de compensation et/ou de formation de signaux selon au moins l'une des revendications 1 à 5, au moyen d'un convertisseur analogique-numérique (19) pouvant fonctionner suivant un procédé Dual-Slope présentant les caractéristiques suivantes:
   - il est prévu un intégrateur (21) et un compensateur (23) situé en aval,
   - il est prévu un dispositif pour la compensation présélectionnable du zéro pour les anomalies des circuits de commutation interne et pour les anomalies de tension des signaux de mesure externes dans lequel le signal de compensation du zéro peut être appliqué à une entrée de l'intégrateur (21) et le signal de mesure analogique peut être appliqué à l'autre entrée ainsi que le signal de tension de référence décalé dans le temps par rapport à celui-ci,
   - il est prévu un dispositif pour le réglage présélectionnable d'une tension de référence différente et un compteur pour déterminer une durée d'intégration pendant l'intégration d'un signal de mesure analogique externe,
   - le dispositif de compensation et/ou de formation de signaux est conçu pour être programmable et être commandé par un microprocesseur,
   - les données de compensation et/ou de formation de signaux peuvent être extraites sous forme numérisée d'une mémoire de données (4) ou être introduites extérieurement par l'intermédiaire d'une interface (3, 29),
   - un circuit de conversion numérique-analogique (33) est monté avant une entrée de l'intégrateur (19),
   - le circuit de conversion numérique-analogique (33) permet de transformer les valeurs de compensation de zéro numérisées en un signal de tension analogique modifiant la différence de tension d'entrée entre les deux entrées de l'intégrateur-convertisseur analogique-numérique (19, 21) et la tension de référence réglable de la manière différente en une tension de référence analogique, et

- il est prévu un compteur programmable (35) au moyen duquel la durée d'intégration du convertisseur analogique-numérique peut être réglée d'une manière présélectionnable de manière différente pour la deuxième phase provoquant une intégration du signal de mesure.

7. Dispositif selon la revendication 6, caractérisé en ce qu'un condensateur est monté avant la deuxième entrée de l'intégrateur (19) servant d'entrée de mesure, ce condensateur pouvant recevoir la tension de compensation de zéro analogique.

8. Dispositif selon la revendication 6 ou 7, caractérisé en ce que le convertisseur numérique-analogique (33) est une mémoire intermédiaire (36) pour mettre en mémoire les valeurs de compensation de zéro numérisé.

9. Dispositif selon l'une des revendications 6 à 8, caractérisé en ce qu'il existe, avant le convertisseur numérique-analogique (33), une mémoire intermédiaire (36) pour mettre temporairement en mémoire les valeurs de tension de référence numérisées.

10. Dispositif selon l'une des revendications 8 ou 9, caractérisé en ce qu'un multiplexeur (38) est monté entre la mémoire intermédiaire (36) et le convertisseur numérique-analogique (33) pour transmettre les valeurs de compensation de zéro ainsi que les valeurs de tension de référence numérisées mises en mémoire dans la mémoire intermédiaire (36).

11. Dispositif selon la revendication 10, caractérisé en ce qu'il est prévu un seul convertisseur numérique-analogique (33) qui est précédé par le multiplexeur (38).

12. Dispositif selon l'une des revendications 6 à 11, caractérisé en ce que les valeurs de compensation, de correction ou de formation de signaux peuvent être extraites d'une mémoire fixe effaçable et programmable électriquement (EEPROM 4), qui peut être raccordée, de préférence, par l'intermédiaire d'une interface (2).

13. Dispositif selon l'une des revendications 6 à 11, caractérisé en ce que les valeurs de compensation, de correction ou de formation de signaux peuvent être extraites d'une mémoire fixe effaçable et programmable électriquement (EEPROM 4), qui est intégrée à la plaquette à semi-conducteur du dispositif.

14. Dispositif selon l'une des revendications 6 à 13, caractérisé en ce que les valeurs de compensation de température qui peuvent être extraites d'une mémoire fixe effaçable et programmable électriquement (EEPROM 4), peuvent être mesurées au moyen d'une tension d'alimentation de pont équivalente aux valeurs de température et peuvent être calculées par interpolation.

15. Dispositif selon l'une des revendications 6 à 14, caractérisé en ce qu'il est prévu, en outre, une compensation de tension d'alimentation par laquelle les déformations des signaux provoquées par les fluctuations de tension peuvent être compensées.

16. Dispositif selon l'une des revendications 6 à 15, caractérisé en ce qu'il est prévu une source de courant programmable pour alimenter en courant et choisir l'intervalle de fonctionnement d'un capteur (5, 7) pouvant y être raccordé.

EP 0 357 616 B1

FIG.1

18

FIG.2

# FIG.3a

Temperatur Profil

T1    T2    T3

Temp. Anstieg    Temp. Anstieg

# FIG.3b

Druck Profil

Startsignal